# EUROPEAN PATENT APPLICATION

(11) **EP 1 914 809 A1**
(43) Date of publication of application: **23.04.2008**
(21) Application number: 06022064.7
(22) Date of filing: 20.10.2006
(51) Int. Cl.: H01L 33/00, H01L 31/0203

(54) **Cover for optoelectronic components**

(71) Applicant: Tridonic Optoelectronics GmbH, 8380 Jennersdorf (AT); Lumitech Produktion und Entwicklung GmbH, 8380 Jennesdorf (AT)
(72) Inventor: Schrank, Franz, Dr., 8074 Raaba (AT); Hoschopf, Hans, 8380 Jennersdorf (AT)
(74) Representative: Rupp, Christian

(57) **Abstract**

A method for manufacturing a LED module comprises the following steps:
- mounting a LED chip on a board,
- making on the board an outer ring made from a liquid resin, the outer ring surrounding the LED chip,
- making a central filling of the volume defined by the outer ring, the central filling being made from a liquid resin and covering the top surface of the LED chip,
- curing in one single step the resin of the outer ring and the central filling and making a chemically linked interface between the outer ring and the central filling.

## Description

The present invention relates to the field of optoelectronic components, such as for example LED modules and light sensors. The cover is designed to allow the directed passage of light to and/or from the component.

The invention also relates to a method for manufacturing such covers and LED modules being provided with such covers.

From the state of the art it is known to cover so called COB (chip-on-board) LED modules with a so called globe-top which is based on a heat-curable resin. Such a globe-top is usually applied with a standard dispensing equipment. However, the performance of LED modules having such a globe-top is not satisfying all requirements of different application fields. One of the main disadvantages actually is the directive characteristics, i.e. the wide emission angle, which is not well suited for using such a LED module with secondary optics, such as for example lenses or light guides.

In order to have a smaller emission angle of the light emitted by COB LED modules the die is sometimes placed in a cavity with a reflecting wall. However, due to the spherical shape of the top surface of the globe-top, the contribution of the reflecting wall on the emission angle is not satisfying.

The second disadvantage of the globe-top cover is the low mechanical stability of the LED modules which is a disadvantage for the handling and mounting of the LED modules. In this context is to be noted that based on the requirements on a high UV stability, usually silicones are used as resins for the globe-top. Unfortunately, these rubber-like materials apply a high mechanical stress to bond wires if the spherical shape of the globe-top is warped.

WO 2006/017484A1 proposes a dam-and-fill technology in order to protect parts of a printed circuit board against electric short circuits.

Therefore, it is the object of the present invention to propose an improved cover for optoelectronic components, which cover allows the directed passage of light to and/or from the component.

This object is achieved by means of the features of the independent claims. The dependent claims develop further the central idea of the present invention.

According to a first aspect of the invention a cover for optoelectronic components, such as for example LED diodes, is proposed. The cover allows for a passage and preferably a directed passage of light to and/or from the component. The cover comprises an outer non-transparent and preferably reflective dam and a central filling, which central filling has been filled into the outer ring preferably after the manufacturing of the outer ring. The outer ring and the central filling are respectively made from a cured resin. The central filling is chemically linked to the outer ring across the interface.

Note that "outer dam" does not represent any limitation as to the shape, as long as the dam can act as a dam surrounding the central filling and being stable in shape even in the uncured state.

The resin can be e.g. silicone.

The dam can comprise reflecting particles such as for example white pigments. The reflecting particles are preferably present throughout the bulk of the outer ring material. The dam thus has the role of a reflector applied in the liquid state on a board.

The outer ring can comprise 10 to 60 weight % of the reflecting particles.

The resin of the outer ring and the central filling can have the same chemical structure, e.g. they can be chemically identical.

The resin of the outer ring can be selected to have a storage modulus of more than 1000 Pa before being cured.

The resin of the outer ring can be selected such that it has for example a viscosity of more than 100 Pa*s when measured at a shear rate of 1 1/s, again before being cured.

The material of the outer ring can comprise particulate material such as e.g. silica, which particular material or fine grained material can be used in order to set the desired rheological properties of the uncured dam resin.

The height of the outer ring can be equal to or more than 1mm.

The mean thickness of the outer ring can be selected according to the requirements of the final element. For a diameter of approx. 5 mm the thickness is equal to or less than 0.5mm. For larger diameters the thickness is adjusted to more than 0.5 mm, for smaller diameters the thickness might be less than 0.5 mm.

The inner diameter of the dam can be as small as e.g. 0.1 to 1mm.

The invention also relates to a light-erasable memory devices, light-sensitive sensors and LED modules having such covers.

The invention can particularly be used for a LED module comprising a LED chip mounted on a board as well as a cover. The cover comprises an outer ring and a central filling, which has been filled into the outer ring and at least partially on top of the LED chip after the outer ring has been made on the board surrounding the LED chip.

The central filling can be made from a transparent resin, such as e.g. silicone.

The central filling can comprise color conversion particles which convert light emitted from the LED chip into light of a second, lower frequency spectrum.

The inner wall of the outer ring can be distanced from the LED chip, such that the distance between the outer ring and the LED chip is filled with the central filling which thus is also in contact with the board on which the LED chip is mounted e.g. in a chip-on-board technology.

The central filling can fill the entire volume defined by the outer ring such that the top surface of the filling is on the same level as the maximum height of the outer ring.

Preferably the outer ring raises higher from the board than the LED-chip.

The invention also relates to a method for manufacturing a cover for electronic or optoelectronic components. An outer ring made from a liquid resin is first dispensed. This outer ring is then filled with a liquid resin. Finally, in one single step, the resin of the outer ring and the resin of the central filling are cured and a chemically linked interface between the outer ring and the central filling is provided which guarantees a stronger adhesion between the central filling and the outer ring.

Further aspects, advantages and objects of the present invention will become evident from the following detailed explanation of embodiments of the present invention when taking in conjunction with the figures of the enclosed drawings.
Fig. 1 shows schematically a side view of a LED module having a cover according to the present invention.
Fig. 2 shows a top view of a LED module with a cover according to the present invention.
Fig. 3 shows a perspective view of a cover of the present invention.
Fig. 4 shows the use of a cover according to the present invention together with a light-erasable storage device, and
Fig. 5 shows the use of the present invention in connection with a light source and a light guiding element.

To start with, a method for manufacturing a cover for optoelectronic components according to the present invention will be explained.

As the cover has a role a optical element, its precision has to go far beyond the precision necessary for purely protective purposes as known from WO 2006/017484A1.

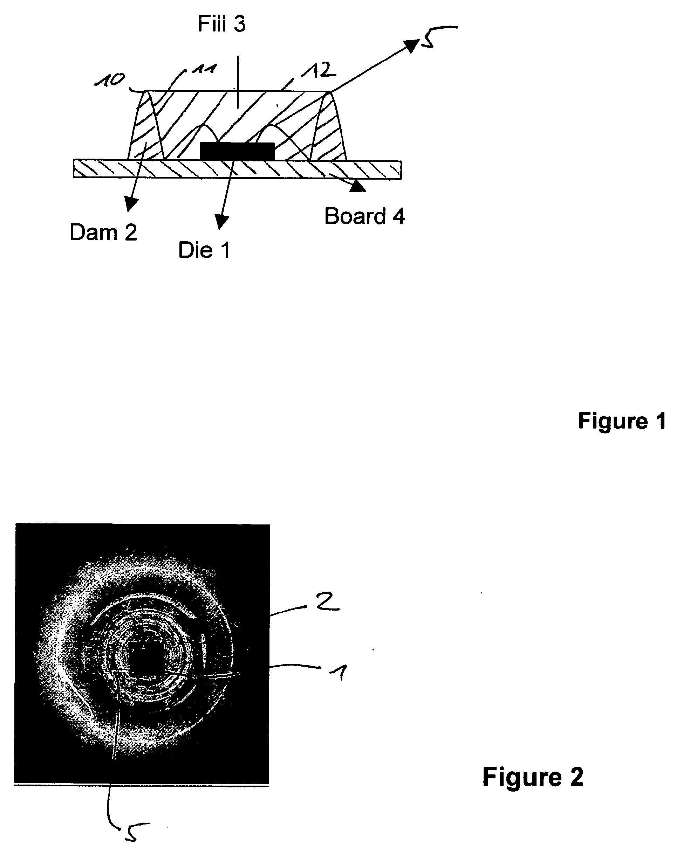

The following method will be explained in the context of producing a cover for a LED module as shown in Fig. 1.

In a first step, a ring-shaped dam (torus) of a liquid resin is dispensed around the LED chip (LED diode) 1, which is placed on a board 4.

Preferably a plane board without recessions is used, as the reflective effect of walls of a recession can be achieved by the dam walls.

Dispensing techniques for resins and silicones are known as such from the prior art. Due to the dispensing technique the cross-sectional view of the dam tapers to the peak 10 of the dam 2. Thus the inner face 11 of dam 2 is inclined and preferably is steeper at its upper part which can be of advantage for reflection purposes.

The cross-sectional shape of the dam 2 can be controlled by the diameter of the dispensing needle used, the flow characteristics of the liquid dam material and the flow (dispensing) speed.

In the example shown in Fig. 1 the LED chip 1 is mounted according to the chip-on-board (COB) technology. The bond wires are designated with the reference numeral 5.

The wall of liquid resin is dispensed on the board 4 around the LED die 1 thus forming a ring.

Preferably the dam material is non-transparent for the wavelength of the light passing through the filling inside the dam (see later on).

Please note that 'ring' in the context of the present description and claims does not constitute any limitation as to the contour of the walls, i.e. the ring does not necessarily have a spherical shape, but can e.g. have the shape of a square, an oval, a rectangular shape etc..

The circular shape is preferred if only a single optically active element is placed inside the dam (see later on), while a rectangular or oval shape is preferred in case a plurality of optically active elements such as LEDs are placed inside the dam in a row configuration.

Different base resins can be used for the ring 2. Preferred materials are silicones due to their high UV stability.

The rheological characteristics of the liquid resin material for building the wall of the ring 2 have to be well selected such that after the dispensing the uncured resin is stable in shape until it is cured.

To this regard the storage modulus should be rather high and e.g. be at least 1000 Pa. The loss factor should be approximately 0.5.

The viscosity of the liquid resin should preferably be higher than 200 Pa*s (when measured at a shear rate of 1 1/s). A liquid resin material of such characteristics is suited for achieving a wall e.g. with a height of more than 1mm and a mean thickness of less than 0.5mm.

In order to adjust the rheological characteristics of the liquid resin material, silica or other particulate material (fine grained material) can be added to the liquid resin.

As can be seen from Fig. 1, preferably the wall 2 is distanced from the LED die 1.

Furthermore, the height of the ring 2 is set to be higher than the height of the LED die 1. E.g. the height of the ring 2 can be twice or three times the height of the LED die 1.

In case a higher light reflectivity of the wall of the ring 2 is desired, optionally reflecting substances such as e.g. white pigments can be added into the liquid resin material. Examples for such pigments are pigments made from TiO₂, BaTiO₃, BaSO₄ and/or ZrO₂.

Preferably, these pigments are added to the liquid resin in an amount of 10% to 60% per weight.

Thus the entire material of the ring will have a non-transparent and preferably white reflecting appearance. The reflection from light from the LED die 1 occurs at the inner face 11 of the ring (or "dam") 2 reflecting light back to the interior of the ring 1 and away from the LED die 1.

In a second step of the manufacturing process the volume confined by the inner walls of the self-stable ring 2 is filled with a liquid filling material. As can be seen from Fig. 1, this filling is preferably made such that the top level of the filling flushes with the top level of the walls of the ring 2. Due to the filling with the liquid resin the top surface 12 of the central filling 3 will be preferably flat.

To summarize, liquid uncured resin is filled in a cavity defined by a self-stable dam of uncured resin, which preferably chemically identical, but can be different regarding optical and mechanical characteristics (as the material of the outer ring 2 can be provided with different "additives" as the material of the central filling 3).

The chemical identity has to be such that the material used for the dam and the filling, respectively, can be cured using the same curing mechanism in order to produce a chemical linking across the interface between the two materials.

The filling material entirely covers the top surface of the LED die 1. It also covers the space between the LED die 1 and the walls of the ring 2 (if any) and contacts the board 4 in this gap between the LED die 1 and the ring 2.

The material for the central filling 3 is also a resin and can be e.g. be made from a silicone material.

Preferably, the resin for the central filling 3 is made from the same material as the resin for the ring 2 such that these resins are chemically identical.

For coloured LED modules (e.g. blue, green, amber and red) it is not necessary to add additional fillers to the resin for the central filling 3.

On the other hand, for white color-conversion LED modules, colour conversion particles can be added to the fill material of the central filling 3. The type and the amount of the colour conversion particles depends on the desired colour temperature of the LED module, which is known as such from the prior art. Preferably there is an increasing concentration gradient of the color conversion particles from the top to the bottom of the filling, which can be achieved e.g. by allowing the color conversion particles to sink towards the bottom of the filling.

In a third step the liquid resins i.e. the resins of the central filling 3 and the ring 2 are cured. By a single curing cycle both of the materials can be cured and chemically linked together at their interface.

The above-outlined manufacturing process relies on a relatively high mechanical stability of the material of the wall in the uncured "liquid" state. Again, in order to achieve this mechanical stability in the liquid state, additional filling materials such as for example silica can be added to the resin for the ring 2.

Both for the manufacturing of the ring 2 as well as for the filling a standard computer controlled dispensing equipment can be used.

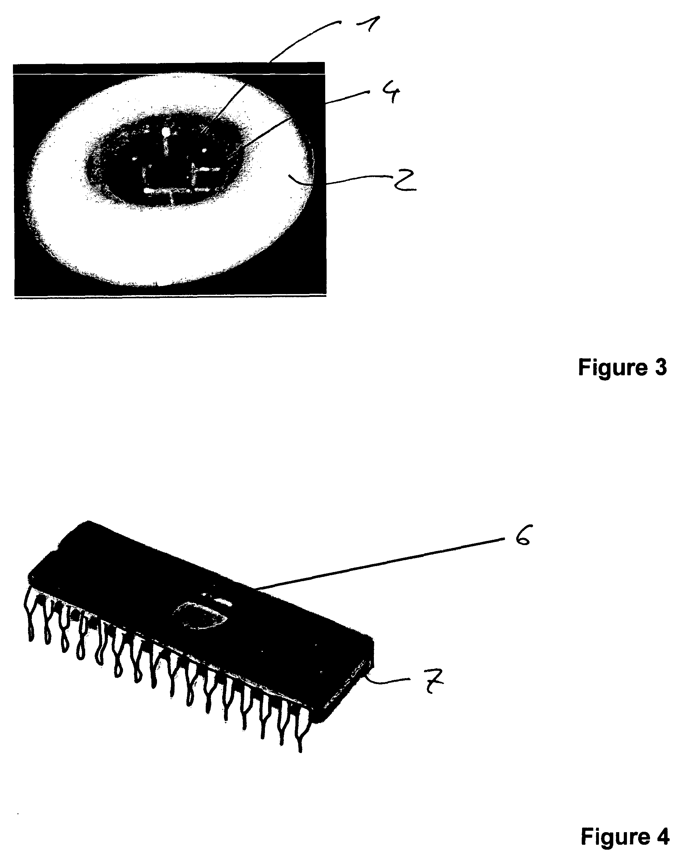

Figures 2 and 3 show a top view (Fig. 2) and a perspective view (Fig. 3) of a LED module having a cover according to the present invention and being mounted in chip-on-board technology. In these examples the material of the ring 2 is highly reflective as white pigments have been added throughout the base resin for the ring 2.

On the other hand, the resin for the filling 3 is essentially transparent and the bond wires 5 can be seen which are surrounded and stabilized by the material of the central filling 3.

As will be explained in the following, the present invention is not limited to LED modules regarding this application, but can also be used in connection with other electronic or optoelectronic components.

In Fig. 4 a light-erasable memory device such as for example a EEPROM 7 is shown.

The cover according to the present invention can protect the opening 6 of the casing of the light erasable memory device 7, which opening is designed for the light erasing process.

Due to the "dam-and-fill" coverage according to the present invention, which can be made of highly transparent materials depending on the requirements of the erasing/programming light beam, a protection against environmental influences as well as perfect fit to the erasing/programming light source can be achieved. Especially, the protection against scattered light and stray light is a big advantage of the dam and fill cover according to the present invention. The outer ring thus can not only serve as a reflective element, but additionally or alternatively as an opaque shielding.

The invention can also be used for light-sensitive sensors such as for example RGB-sensors, infrared sensors or CCD-sensors.

Also infrared emitters as well as light sensitive light detection devices coated and protected through a cover as explained above are additional field of the application, in particular when the sensor is present as a bare chip in COB or Leadframe-Technology.

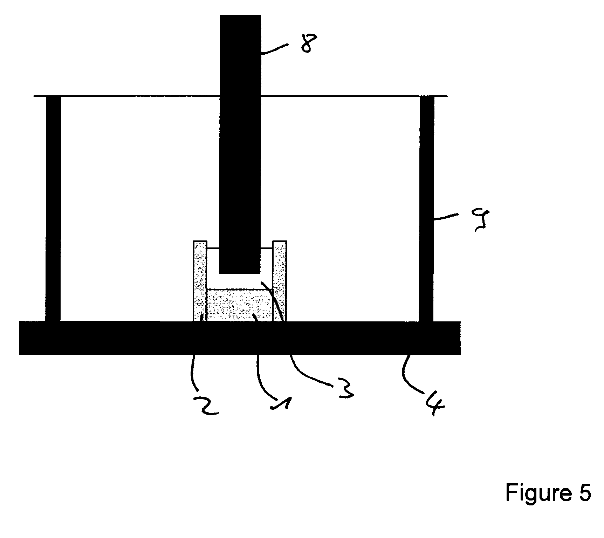

Finally, Fig. 5 shows the use of a cover according to the present invention in connection with light guides and optical fibers.

The dam material (ring) 2 provides a mechanical stability, such that it is possible to provide the filling 3 on top of the light source as a very fluid and highly transparent synthetic resin.

In the example shown in Fig. 5 there is no gap between the ring 2 and the light source 1 such that the filling material is only present on top of the light source 1.

Furthermore, the filling 3 is not completely flush with the top of the wall of the ring 2.

The reference sign 8 designates an optical fiber to which light from the light source 1 is to be transmitted (transversing the fill material 3).

The reference sign 9 designates mechanical fixture for optical fibers.

The arrangement as shown in Fig. 5 provides for an improved light feeding from the light source to the optical fibre.

## Claims

1. A cover for optoelectronic components,
the cover comprising an outer non-transparent dam (2) and a central filling (3), which has been filled into the outer ring (2),
the outer ring (2) and the central filling (3) being respectively made from a cured resin,
the central filling (3) being chemically linked to the outer ring (2).

2. The cover according to claim 1,
wherein the resin comprises silicone.

3. The cover according to any of the preceding claims,
wherein the outer ring (2) comprises reflecting particles.

4. The cover according to claim 3,
wherein the reflecting particles are white pigments.

5. The cover according to claim 3 or 4,
wherein the outer ring (2) comprises 10 to 60 weight % of reflecting particles.

6. The cover according to any of the preceding claims,
wherein the resin of the outer ring (2) and the central filling (3) have the same chemical structure.

7. The cover according to any of the preceding claims,
wherein the resin of the outer ring (2) has a storage modulus of more than 100 Pa.

8. The cover according to any of the preceding claims,
wherein the resin of the outer ring (2) has a viscosity of more than 100 Pa*s when measured at a shear rate of 1 1/s.

9. The cover according to any of the preceding claims,
wherein the material of the outer ring (2) comprises particulate material such as e.g. silica.

10. The cover according to any of the preceding claims,
wherein the height of the outer ring (2) has at least the height of the element to be covered.

11. A light-erasable memory device, comprising a cover according to any of the preceding claims.

12. A light-sensitive sensor, comprising a cover according to any of claims 1 to 10.

13. A LED module comprising a cover according to any of claims 1 to 10.

14. A LED and/or sensor module comprising a LED and/or sensor chip (1) mounted on a board and a cover, the cover comprising an outer ring (2) and a central filling (3), which has been filled into the outer ring (2) and at least partially on top of the LED chip (1) after the outer ring (2) has been made on the board surrounding the LED and/or sensor chip (1),
the outer ring (2) and the central filling (3) being respectively made from a cured resin,
the central filling (3) being chemically linked to the outer ring (2).

15. The LED and/or sensor module according to claims 12 and 13,
wherein at least the inner wall of the outer ring (2) is light-reflective.

16. The LED and/or sensor module according to claim 14 or 15,
wherein at least the central filling (3) is made from a transparent resin.

17. The LED module according to any of claims 14 to 16,
wherein the central filling (3) comprises color conversion particles.

18. The LED and/or sensor module according to any of claims 14 to 17,
wherein the LED chip (1) is mounted on the board according to a chip-on-board technology.

19. The LED and/or sensor module according to any of claims 14 to 18,
wherein the LED and/or sensor chip (1) is mounted on a chip including the electrical circuit for operating the LED and/or sensor chip..

20. The LED and/or sensor module according to any of claims 14 to 19,
wherein the inner wall of the outer ring (2) are distanced from the LED and/or sensor chip (1), the distance between the outer ring (2) and the LED chip (1) being filled with the central filling (3).

21. The LED and/or sensor module according to any of claims 14 to 20,
wherein the central filling (3) fills the entire volume defined by the outer ring (2).

22. The LED and/or sensor module according to any of claims 14 to 21,
wherein the outer ring (2) is higher than the LED chip (1).

23. The LED and/or sensor module according to any of claims 14 to 22,
wherein the height of the outer ring (2) has at least the height of the element to be covered.

24. A method for manufacturing a cover for electronic or optoelectronic components,
the method comprising the following steps:
- making an outer ring (2) made from a liquid resin,
- making a central filling (3) of the volume defined by the outer ring (2), the central filling (3) being made from a liquid resin,
- curing in one single step the resin of the outer ring (2) and the central filling (3) and making a chemically linked interface between the outer ring (2) and the central filling (3).

25. A method for manufacturing a LED module,
the method comprising the following steps :
- mounting a LED chip (1) on a board,
- making on the board an outer ring (2) made from a liquid resin, the outer ring (2) surrounding the LED chip (1),
- making a central filling (3) of the volume defined by the outer ring (2), the central filling (3) being made from a liquid resin and covering the top surface of the LED chip (1),
- curing in one single step the resin of the outer ring (2) and the central filling (3) and making a chemically linked interface between the outer ring (2) and the central filling (3).

26. The method according to any of claims 24 or 25,
wherein the outer ring (2) and/or the central filling (3) are made by dispensing.

27. A method for manufacturing a non-transparent and preferably reflective element around a LED chip of a LED module,
the method comprising the following steps:
- mounting a LED chip (1) on a preferably plane board,
- making on the board an outer ring (2) made from a liquid non-transparent resin-based material, the outer ring (2) surrounding the LED chip (1), and
- making a central filling (3) of the volume defined by the outer ring (2), the central filling (3) being made from a liquid resin and covering the top surface of the LED chip (1).
